# EUROPEAN PATENT SPECIFICATION

(11) **EP 3 806 168 B1**
(45) Date of publication and mention of the grant of the patent: **22.11.2023**
(21) Application number: 18922756.4
(22) Date of filing: 11.06.2018
(51) Int. Cl.: H01L 33/00, H01L 25/075

(54) **LIGHT-EMITTING COMPONENT**
LICHTEMITTIERENDES BAUELEMENT
COMPOSANT ÉLECTROLUMINESCENT

(43) Date of publication of application: 14.04.2021
(73) Proprietor: Xiamen San'an Optoelectronics Co., Ltd., Fujian Province 361100 (CN)
(72) Inventor: LIU, Tung-Kai, Xiamen, Fujian 361009 (CN); TING, Shao-ying, Xiamen, Fujian 361009 (CN); HSU, Chen-ke, Xiamen, Fujian 361009 (CN); LEE, Chia-en, Xiamen, Fujian 361009 (CN)
(74) Representative: Petraz, Gilberto Luigi
(86) International application number: PCT/CN2018/090673
(87) International publication number: WO 2019/237228

(56) References cited:
- CN-A- 101 794 848
- CN-A- 101 859 728
- CN-A- 107 408 603
- CN-A- 107 946 415
- CN-A- 107 978 548
- CN-A- 107 978 548
- US-A1- 2008 081 400
- US-A1- 2016 197 232
- US-A1- 2017 243 773
- US-A1- 2020 273 848

## Description

### TECHNICAL FIELD

The present invention relates to the field of semiconductor manufacturing, and more particularly relates to a light-emitting assembly for an application terminal.

### BACKGROUND

In the current market, a micro-light-emitting diode (MicroLED) chip is attracting attention in a wide range of applications such as a biosensor, automotive lighting, a display, a flexible device, an optical communication and a visual reality device. A tiny size and a tiny structure of the MicroLED chip lead to a reduction in spacing and an increase in external quantum efficiency, which is a revolution for optoelectronic devices. However, a thin and sophisticated architecture of MicroLED chips makes it difficult to transfer the chips and is time-consuming. For example, if a transfer process is based on a traditional surface mounting machine, 6 million MicroLED chips may require a 1-month transfer cycle. The transfer process of the micro LED chips used in a mass production process is inefficient.

Although many companies provide solutions for transfer, there are some problems in mass production. In mass production, each transfer of the MicroLED chips may reduce the production of a product. In other words, because a pick and place process involves a pressure change and a thermal change of a transfer head and a substrate, excessive thermal transfer will increase the number of bonding failures of the Micro LED chips.

US2008081400A1 discloses a device transfer method in which, in transferring devices arranged on a substrate onto another substrate, it is possible to easily strip the substrate after the transfer of the devices, to lower the possibility of damaging of the substrate, and to additionally transfer devices onto the same substrate after the transfer of the devices. CN107978548A discloses a method of mass transferring LEDs in which, a photosensitive material layer is formed and cured on the substrate to attach LEDs, the photosensitive material layer is then divided into multiple support structures that support LEDs, using the LED array as a mask. US20160197232A1 discloses an assembly of LED, in which, patterned structure on growth substrate is bonded to a carrier substrate with an adhesive bonding material to form stabilization layer.

### SUMMARY

The present invention provides a light-emitting assembly as defined in claim 1, that includes a plurality of light-emitting diodes and a support configured to support the light-emitting diodes. The light-emitting diode includes a semiconductor layer sequence composed of at least a first type semiconductor layer, a second type semiconductor layer, and an active layer located between the first type semiconductor layer and the second type semiconductor layer. The light-emitting diode further includes a first electrical contact layer electrically connected to the first type semiconductor layer, and a second electrical contact layer electrically connected to the second type semiconductor layer. A continuous or discontinuous adhesive film for adhering the light-emitting diodes is provided between the support and the light-emitting diodes, and the light-emitting diodes are arranged on the adhesive film in a regular arrangement. The adhesive film is a material that can grab a die of the light-emitting diode.

The present invention further provides a light-emitting device as defined in claim 9, which includes a substrate circuit and the above light-emitting assembly. The light-emitting assembly is bonded to the substrate circuit.

The present invention further provides a method for manufacturing a light-emitting assembly as defined in claim 10. The light-emitting assembly is configured to bond a light-emitting diode to a substrate circuit. The light-emitting diode comprises a semiconductor sequence which is composed of at least a first type semiconductor layer, a second type semiconductor layer, and an active layer located between the first type semiconductor layer and the second type semiconductor layer. The light-emitting diode further includes a first electrical contact layer electrically connected to the first type semiconductor layer, and a second electrical contact layer electrically connected to the second type semiconductor layer. The method includes: step (1), providing a support configured to support the light-emitting assembly, and coating a layer of adhesive film on the support; and step (2), adhering a die of the light-emitting diode at a first light-emitting wavelength and a die of the light-emitting diode at a second light-emitting wavelength different from the first light-emitting wavelength, to the adhesive film to obtain the light-emitting assembly. The dies of the light-emitting diodes are adhered to the adhesive film in batches according to the different types of the dies.

The present invention further provides a method for manufacturing a light-emitting device as defined in claim 14. The light-emitting device includes a substrate circuit. The method includes the above method for manufacturing a light-emitting assembly. The method further includes bonding the light-emitting assembly to the substrate circuit.

Other features and advantages of the present invention will be described in the following description, and partly become obvious from the description, or understood by implementing the present invention. The purpose and other advantages of the present invention can be realized and obtained through the structures specifically pointed out in the specification, claims and drawings.

### BRIEF DESCRIPTION OF THE DRAWINGS

The accompanying drawings are used to provide a further understanding of the present invention, and constitute a part of the specification. Together with the embodiments of the present invention, they are used to explain the present invention and do not constitute a limitation to the present invention. In addition, the figure data is a descriptive summary, is not drawn to scale.
FIG. 1 is a schematic diagram of a structure of a light-emitting assembly according to a first embodiment.
FIG. 2 is a schematic diagram of a structure of a light-emitting assembly according to some modified embodiments of the first embodiment.
FIG. 3 is a schematic diagram of a structure of a light-emitting assembly according to a second embodiment.
FIG. 4 is a schematic diagram of a structure of a light-emitting assembly according to a third embodiment.
FIG. 5 is a schematic diagram of a structure of a light-emitting device according to a fourth embodiment.
FIG. 6 and FIG. 7 are schematic diagrams of a method for manufacturing a light-emitting assembly according to a fifth embodiment.
FIG. 8 is a schematic diagram of a structure of a light-emitting device manufactured according to a seventh embodiment.

Description of Reference Numerals: 100, light-emitting diode; 110, semiconductor layer sequence; 121, first electrical contact layer; 122, second electrical contact layer; 200, support; 300, adhesive film; 310, plateau-shaped protrusion; 311, platform; 400, substrate circuit; 500, protective layer.

### DETAILED DESCRIPTION OF THE PREFERRED EMBODIMENTS

The implementation of the present invention will be described in detail below with reference to the accompanying drawings and embodiments, so as to fully understand how the present invention applies a technical mean to solve a technical problem and achieve a realization process of a technical effect and implements them accordingly. It should be noted that, as long as there is no conflict, each embodiment of the present invention and each feature in each embodiment can be combined with each other, as long as the result is within the scope of the invention which is defined by the appended claims.

It should be understood that the terms used in the present invention are only for the purpose of describing specific embodiments, and are not intended to limit the present invention. It is further understood that when the terms "comprising" and "including" are used in the present invention, they are used to indicate the existence of the stated features, wholes, steps, elements, and/or combinations thereof, and do not exclude the presence or addition of one or more other features, wholes, steps, elements, and/or combinations thereof.

Unless otherwise defined, all terms (including technical and scientific terms) used in the present invention have the same meaning as commonly understood by those of ordinary skill in the art to which the present invention belongs. It should be further understood that the terms used in the present invention should be understood as having meanings consistent with the meanings of these terms in the context of this specification and related fields, and should not be understood in an idealized or overly formal sense, unless explicitly defined as such in the present invention.

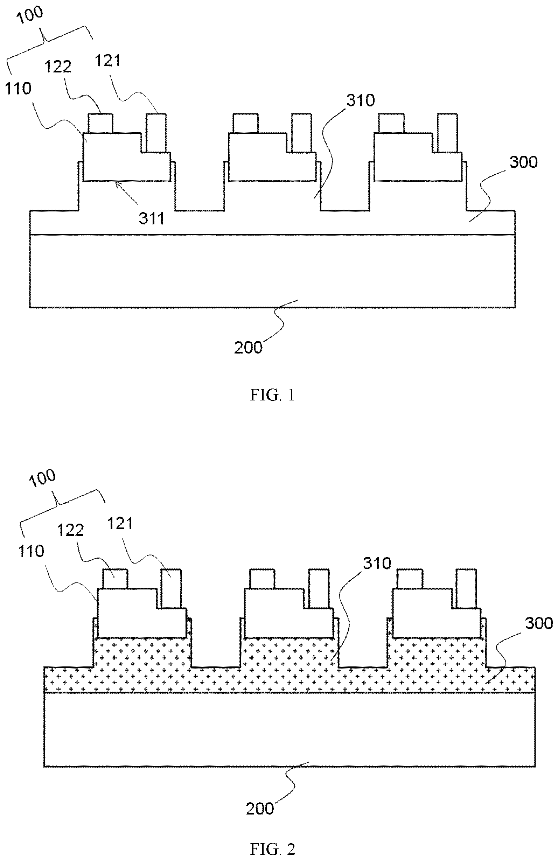

Referring to FIG. 1, in a first embodiment of the present invention, a light-emitting assembly is provided. The light-emitting assembly is used to be directly bonded to a substrate circuit. The light-emitting assembly, which is to be soldered to the application terminal, includes a plurality of diodes 100. The light-emitting diode 100 includes a semiconductor layer sequence 110. The semiconductor sequence 110 is composed of at least a first type semiconductor layer, a second type semiconductor layer, and an active light-emitting layer located between the first type semiconductor layer and the second type semiconductor layer. The light-emitting diode 100 further includes a first electrical contact layer 121 electrically connected to the first type semiconductor layer, and a second electrical contact layer 122 electrically connected to the second type semiconductor layer.

A support 200 that provides a support for the light-emitting diodes 100 includes a wafer composed of sapphire, gallium arsenide, silicon or silicon carbide or the like. The support 200 is used to stably support the light-emitting diode 100. Stability of the support 200 in deformation can provide good matching accuracy for the light-emitting diodes 100 when being bonded to a light-emitting device. As a special case, a surface of the support 200 has adhesiveness itself, thereby taking into account the functions of both stable support and adhesion.

A continuous or discontinuous adhesive film 300 for adhering the light-emitting diodes 100 to the support 200 is provided between the support 200 and the light-emitting diodes 100, and the light-emitting diodes 100 are arranged on the adhesive film in a regular arrangement. In this embodiment, the regular arrangement is obtained by dividing the light-emitting diodes 100 into a plurality of batches selectively and actively, and adhering them onto the adhesive film 300 in a certain regular arrangement. The certain regular arrangement includes an arrangement of different light-emitting wavelength combinations, an arrangement of specific position or an arrangement of different size combinations. The light-emitting assembly of this embodiment has an ability to be directly bonded to a package substrate, reduces the number of times of directly bonding light-emitting diodes in different specifications to the package substrate circuit 400 in batches, thereby reducing a probability of failing bonding to the package substrate and a production cost, and facilitating the client to directly mount/bond the light-emitting assembly to an application device.

In an actual process, the adopted arrangement of different light-emitting wavelength combinations includes a blue-blue-blue arrangement, a blue-green-red arrangement, a blue-green-green-red arrangement, a blue-green-green-red-red arrangement or a blue-green-red-red arrangement, or the like. Different visual or optical effect at an application terminal are obtained with combinations of different wavelengths and numbers. In this type of application, compared to bonding the light-emitting diode 100 to an application terminal in batches in the prior art, the embodiment of the present invention has a particularly obvious efficiency improvement and yield advantage. According to a demand of an application terminal, the arrangement of different size combinations includes a plurality of combinations such as different thicknesses, different light-emitting areas or different shapes.

In this embodiment, in order to improve plasticity of the adhesive film 300, and realize a patterning or roughening process of the adhesive film 300, the adhesive film 300 is selected as a removable material. A removal method of the removable material includes but is not limited to chemical decomposition, physical decomposition, for example, photolysis or thermal decomposition and other technical means. The adhesive film 300 has a function of fixing the light-emitting diodes 100, and some adhesive film 300 in this embodiment is capable of releasing the light-emitting diodes 100 under a physical or chemical action. In order to reduce an interference of the adhesive film 300 on the bonding process, a surface of the adhesive film 300 is partially and selectively removed to provide a plurality of plateau-shaped protrusions 310. A surface of a platform 311 of the plateau-shaped protrusion 310 is in contact with the light-emitting diode 100. A shape of the plateau-shaped protrusion 310 can be selected according to an actual need without being subject to a specific restriction. For example, the shape of the plateau-shaped protrusion 310 is a cuboid, a truncated cone, a prism, or other columnar structure. A thickness of the adhesive film 300 is 5-100 µm, and a spacing between the plateau-shaped protrusions 310 is 20-600 µm. In the invention, a height of the plateau-shaped protrusion 310 is designed to be greater than a thickness of the light-emitting diode 100, and the height of the plateau-shaped protrusion 310 is 10-20µm. The plateau-shaped protrusions 310 are formed by removing at least a part of the adhesive film 300 between the light-emitting diodes 100 after adhering the light-emitting diodes 100, for example, removing a depth of 10-20 µm relative to the height of the plateau-shaped protrusion 310.

The adhesive film 300 is in a stable structure during a process from adhering the light-emitting diodes 100 to completing the final bonding to the substrate circuit 400, and can provide a stable chemical or physical state for a long time, such as a certain range of temperature resistance, a certain vibration resistance or an ability of resisting air oxidation. The protective layer provides protection to the contact layers and the semiconductor sequence, so that the bonding process can be completed with high efficiency, accurate matching and good reliability when the light-emitting diodes 100 are bonded to the package substrate. In this embodiment, the light-emitting diodes 100 are adhered to the adhesive film 300, and the adhesiveness and/or flexible clamping force of the adhesive film 300 is used to provide support for the light-emitting diodes. The sidewall of the light-emitting diode 100 is provided with a thin film made of a material of the adhesive film. A selection range of the material of the adhesive film 300 includes polyimide, ultraviolet photosensitive adhesive, heat-sensitive adhesive, hydrosol, and silica gel. In this embodiment, a structure of the light-emitting diode 100 is not limited to a face up type structure, a flip type structure, or a vertical type structure. In order to improve light extraction efficiency and facilitate bonding, the light-emitting diode 100 of the present embodiment is preferably a flip chip structure.

In the first embodiment, the light-emitting diodes 100 are mainly selected from micro light-emitting diodes in micro size. For example, light-emitting diode is in a length from 2 µm to 5 µm, from 5 µm to 10 µm, from 10 µm to 20 µm, from 20 µm to 50 µm, or from 50 µm to 100 µm. The light-emitting diode is in a width from 2 µm to 5 µm, from 5 µm to 10 µm, from 10µm to 20 µm, from 20 µm to 50 µm, or from 50 µm to 100 µm. The light-emitting diode is in a height from 2 µm to 5 µm, from 5 µm to 10 µm.

Referring to FIG. 2, in some modified embodiments of the first embodiment, some special designs are made to the thin film provided on the sidewall of the light emitting diode, to improve performance. For example, the thin film is made as a total reflection film or an antireflection film. For example, in this modified embodiment, the thickness of the thin film is less than 3 µm, and the refractive index of the thin film is 1.2-2. In this embodiment, the thin film is composed of the adhesive film 300. In order to be adhered to the sidewall of the light-emitting diode 100 more stably, the hardness of the adhesive film 300 is preferably 15-50J/m3. The refractive index of the film may be determined by a material characteristic of the adhesive film 300 itself, or may also be achieved by doping the adhesive film 300 locally or entirely.

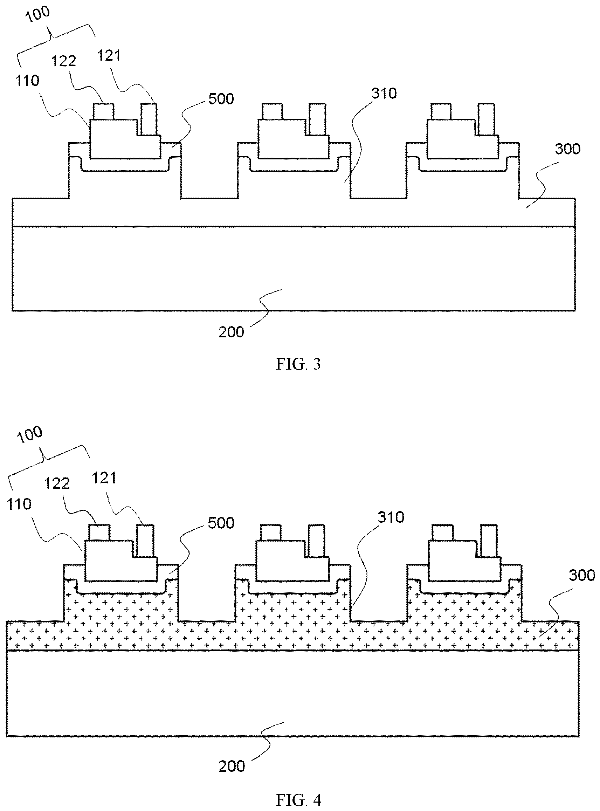

Referring to FIG. 3, in the second embodiment of the present invention, in order to enhance reliability of the light-emitting assembly, the light-emitting diode 100 is provided with a protective layer 500 on a surface contacting the adhesive film 300 and/or on a sidewall adjacent to the surface contacting the adhesive film 300. The function of the protective layer 500 includes corrosion resistance, moisture resistance or oxidation resistance. For example, oxidation of the electrical contact layer is prevented or the reliability of the light-emitting assembly is improved in a humid environment. A material of the protective layer 500 includes a material that can improve the reliability of the light-emitting assembly silicon, silicon oxide, silicon nitride, or epoxy resin or the like.

As some modifications of the second embodiment, the protective layer 500 can be replaced by a packing adhesive or a wavelength conversion material, which has the functions of simplifying the packaging process and protecting the light-emitting diode.

Referring to FIG. 4, a third embodiment of the present invention is provided by combining some modified embodiments of the first embodiment with the feature of the solution of the second embodiment. That is, the material of the adhesive film 300 in this embodiment has the optical characteristic of some modified embodiments of the first embodiment, and at the same time, the surface of the adhesive film 300 is provided with a protective layer 500. Specifically, when the adhesive film 300 uses a material that has an impact on the performance of the light-emitting diode 100, the light-emitting diode 100 needs to be protected by the protective layer 500 having an insulating function.

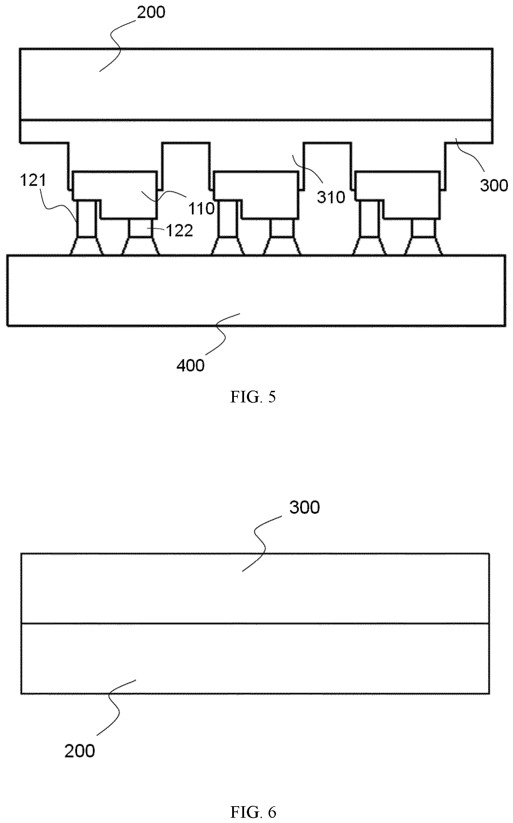

Referring to FIG. 5, the fourth embodiment of the present invention mainly provides an application mode of the light-emitting assembly. This embodiment discloses a light-emitting device, which includes the light-emitting assembly of any one of the above-mentioned embodiments. The light-emitting assembly is bonded to the substrate circuit 400. The substrate circuit 400 is provided with, for example, a number of switches corresponding to the number of light-emitting diodes 100 in the light-emitting assembly. The switches respectively control the brightness of each light-emitting diode 100. Obviously, based on a need of the application terminal, the substrate circuit 400 may also include one or more series circuits to constitute a light-emitting device.

In the fifth embodiment of the present invention, the present invention mainly provides a method for manufacturing a light-emitting assembly. The light-emitting assembly is configured to be bonded to the substrate circuit 400. The method includes the followings.

The process method is to provide a temporary bonding material as the support 200 to temporarily fix the light-emitting diode 100, and the arrangement of the light-emitting diode 100 can be designed with the appearance of the substrate circuit 400 of the final application terminal. Efficient arrangement and transfer is implemented through a mass transfer process of the light-emitting diode 100. The mass transfer process can place the blue, green, and red light-emitting diodes 100 on the temporary bonding material in multiple times. Then, the temporary bonding material carrying the blue, green, and red light-emitting diodes 100 is aligned with the final substrate, and a one-time thermocompression bonding is performed, so that the blue, green, and red light-emitting diodes 100 can be bonded to the final substrate. After the entire bonding process is completed, the temporary bonding material can be removed from the final substrate to complete the electrical connection of the blue, green, and red light-emitting diodes 100.

The temporary bonding material mentioned in the present disclosure refers to a temporary and removable support 200, which can provide temporary bonding for the blue, green, and red light-emitting diodes 100. After the bonding process is completed, the support 200 can be removed from the final substrate. This temporary bonding material is provided with the adhesive film 300 with high recovery coefficient and high hardness, and can withstand a temperature up to 350 degrees Celsius, or can be other composite materials.

Corresponding to the drawings, referring to FIG. 6, in step (1), a support 200 configured to support the light-emitting assembly is provided. The support 200 includes a wafer composed of sapphire, gallium arsenide, silicon, or silicon carbide or the like. The support 200 is coated with a layer of adhesive film 300 through a printing process;

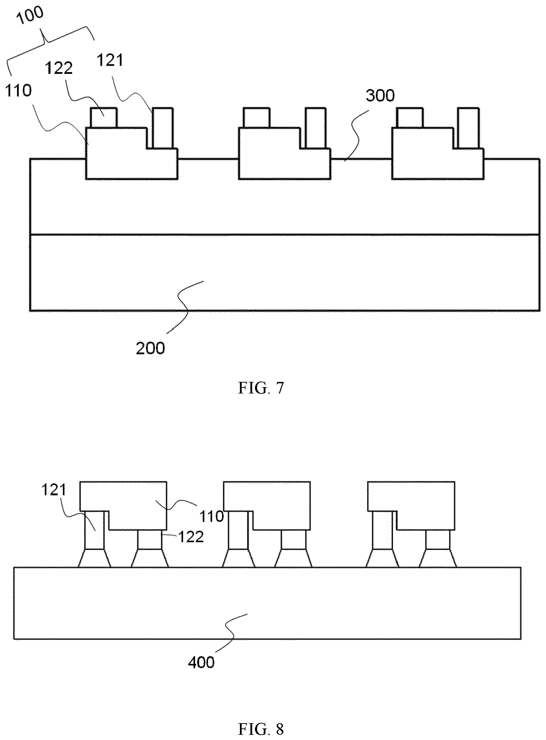

Referring to FIG. 7, in step (2), a first type of die of the light-emitting diode and a second type of die of the light-emitting diode different from the first type is adhered to the adhesive film 300 in batches according to different types, to obtain the light-emitting assembly. It should be understood that this embodiment only uses two types of dies of the light-emitting diodes as examples, and the number of types is not limited in the present invention. The die of the light-emitting diode 100 includes a semiconductor sequence 110, and the light-emitting diode 100 includes the first electrical contact layer 121 electrically connected to the first type semiconductor layer, and the second electrical contact layer 122 electrically connected to the second type semiconductor layer. The first electrical contact layer 121 and the second electrical contact layer 122 are located on a surface of a side of the light-emitting diode 100 away from the adhesive film 300.

Referring back to FIG. 1, in step (3), a part of the adhesive film 300 between the dies of the light-emitting diodes 100 is removed, and the adhesive film 300 is made into a structure with plateau-shaped protrusions 310, so as to produce the light-emitting assembly. As an alternative to this step, a plurality of plateau-shaped protrusions 310 can be formed on the surface of the adhesive film before the adhesive film 300 is adhered with the dies of the light-emitting diodes 100.

In some modified embodiments of the fifth embodiment, the protective layer 500 is coated on the adhesive film after step (1), and the protective layer 500 can be selected from a rigid material or a flexible material. The protective layer 500 may be discretely or continuously distributed on the adhesive film 300. When the protective layer 500 is continuously distributed, the position of the protective layer 500 corresponds to the distribution position of the subsequent light-emitting diodes 100 to provide a better protection effect. The function of the protective layer 500 includes corrosion resistance, moisture resistance, or oxidation resistance. For example, the oxidation of the electrical contact layer is prevented or the reliability of the light-emitting assembly is improved in a humid environment. The material of the protective layer 500 includes a material that can improve the reliability of the light-emitting assembly such as silicon, silicon oxide, silicon nitride, or epoxy resin or the like. In this modified embodiment, in addition to adding the protective layer 500 by coating, the protective characteristic can also be achieved by doping the surface or the entire of the adhesive film 300, thereby improving the accuracy of the protective process. Another function of the protective layer 500 is to avoid or reduce the residue of an adhesive on the light-emitting diode 100 during the subsequent removing process of the adhesive film 300, so as to overcome the defects of light performance such as brightness or light type otherwise caused thereby.

The sixth embodiment provided on the basis of the fifth embodiment of the present invention provides a method for manufacturing a light-emitting device. The sixth embodiment includes step (4). Referring back to FIG. 5, the light-emitting assembly obtained in step (3) of the fifth embodiment is directly aligned and bonded to the substrate circuit 400 to manufacture the light-emitting device. The substrate circuit 400 has a function of controlling any of the light-emitting diodes 100 on the light-emitting assembly.

Referring to FIG. 8, on the basis of the sixth embodiment, the seventh embodiment of the present invention may further include step (5). In this step, the adhesive film 300 and/or the support 200 is/are removed after bonding, and the main purpose is to improve the light extraction efficiency. In this embodiment, whether to remove the adhesive film 300 will be determined according to the characteristic of the adhesive film 300.

The embodiments of the present invention propose a feasible solution to a problem in the background art. The present invention provides a novel micro light-emitting diode assembly for mass production. In the chip manufacturing process, a series of MicroLED chip transfer process is completed, and then a film with B, G, R chip beans is delivered to an application terminal. This kind of assembly can strengthen a quality of a product in the application terminal, and the light-emitting assembly with high bonding efficiency can be obtained on the application terminal through this technical solution.

The beneficial effects of the embodiments of the present invention include the followings.
(1) By arranging the light-emitting diodes regularly on the adhesive film as a product for sale, the light-emitting assemblies in various specifications that can be quickly bonded can be provided on the application terminal, working efficiency of the application terminal is increased, and an additional value of the chip can also be increased.
(2) By transferring the light-emitting assemblies with light-emitting diodes in different specifications to the adhesive film multiple times and then bonding the light-emitting assemblies to the substrate circuit at one time, which is used to replace a process flow of transferring different light-emitting diodes to the substrate circuit multiple times in an existing mode, a negative effect, such as destruction or damage, on the substrate circuit in transfer process is reduced.
(3) The adhesive film is a removable material, which provides a possibility of making various patterns in the light-emitting assembly, so as to adapt to a bonded substrate of different surface conditions in a practical application, and better meet a demand of a client.
(4) A surface of the adhesive film is provided with plateau-shaped protrusions to overcome an interference of complex surface conditions of the bonded substrate in the practical application.
(5) The height of the plateau-shaped protrusions should be greater than the thickness of the light-emitting diode or the height of the plateau-shaped protrusions should be 10~20µm, to avoid the support from warping due to a processing stress, which causes the light-emitting diode in a warped portion to touch the surface of the substrate before the light-emitting assembly is bonded to the substrate under the pressure. Thus, a safety distance is reserved by setting the height of the plateau-shaped protrusion.
(6) The sidewall of the light-emitting diode is provided thereon with the residual adhesive film. On one hand, it is due to a process residue. On the other hand, it can also be designed and manufactured into a total reflection mirror structure by selecting the refractive index of the film.
(7) The light-emitting diode is provided with a protective layer on the side contacting the adhesive film and/or on the sidewall adjacent to the side contacting the adhesive film, to reduce or prevent the light-emitting diode from being affected by a working environment, which results in a decrease in the performance of the light-emitting diode.

The above are only the preferred embodiments of the present invention. It should be pointed out that for those skilled in the art, without departing from the principle of the present invention, several improvements and modifications can be made which are within the protection scope of the present invention, which is defined by the appended claims.

## Claims

1. A light-emitting assembly, comprising:
a plurality of light-emitting diodes (100), the light-emitting diode (100) comprising a semiconductor layer sequence (110) composed of at least a first type semiconductor layer, a second type semiconductor layer, and an active layer located between the first type semiconductor layer and the second type semiconductor layer, the light-emitting diode (100) further comprising a first electrical contact layer (121) electrically connected to the first type semiconductor layer and a second electrical contact layer (122) electrically connected to the second type semiconductor layer,
a support (200) configured to support the light-emitting diodes (100); and
a continuous or discontinuous adhesive film (300) for adhering the light-emitting diodes (100), provided between the support (200) and the light-emitting diodes (100), the light-emitting diodes (100) being arranged on the adhesive film (300) in a regular arrangement,
wherein a plurality of plateau-shaped protrusions (310) are provided on a surface of the adhesive film (300) and a convex surface of the plateau-shaped protrusions (310) is in contact with the light-emitting diodes (100), **characterised in that** a height of the plateau-shaped protrusion (310) is 10-20 µm which is greater than a thickness of the light-emitting diode (100).

2. The light-emitting assembly according to claim 1, wherein the adhesive film (300) is a removable material, the adhesive film (300) being capable of fixing the light-emitting diodes (100) and releasing the light-emitting diodes (100) under a physical or chemical acti on.

3. The light-emitting assembly according to claim 1, wherein a shape of the plateau-shaped protrusion (310) is a cuboid, a truncated cone, a prism or other columnar structure, and a spacing between the plateau-shaped protrusions (310) is 20-600 µm.

4. The light-emitting assembly according to claim 1, wherein a sidewall of the light-emitting diode (100) is provided with a thin film made of a material of the adhesive film (300), a thickness of the thin film (320) being 3-10 µm, a refractive index of the thin film (320) being 1.2-2, a hardness of the adhesive film (300) being 15-50 J/m³ a material of the adhesive film (300) comprising polyimide, ultraviolet photosensitive adhesive, heat-sensitive adhesive, hydrosol, or silica gel.

5. The light-emitting assembly according to claim 1, wherein the structure of the light-emitting diode (100) comprises a face up chip structure, a flip chip structure or a vertical structure, the light-emitting diode (100) being provided with a protective layer (500) on a surface contacting the adhesive film (300) and/or on a sidewall adjacent to the surface contacting the adhesive film (300).

6. The light-emitting assembly according to claim 1, wherein a combination manner of the regular arrangement comprises an arrangement of different light-emitting wavelength combinations, an arrangement of different spacing combinations, or an arrangement of different size combinations, and preferably, the arrangement of different size combinations includes an arrangement of different thickness, an arrangement of different light-emitting areas or an arrangement of different shapes.

7. The light-emitting assembly according to claim 1, wherein the light-emitting assembly is configured to be bonded to a substrate circuit (400), and has a function of transferring a plurality of light-emitting diodes (100) from the support (200) to the substrate circuit (400) at a time, a material of the support (200) comprising sapphire, gallium arsenide, silicon or silicon carbide.

8. The light-emitting assembly according to claim 1, wherein the light-emitting diode (100) is in a length from 2 µm to 5 µm, from 5 µm to 10 µm, from 10 µm to 20 µm, from 20 µm to 50 µm, or from 50 µm to 100 µm, in a width from 2 µm to 5 µm, from 5 µm to 10 µm, from 10 µm to 20 µm, from 20 µm to 50 µm, or from 50 µm to 100 µm, and in a height from 2 µm to 5 µm, or from 5 µm to 10 µm.

9. A light-emitting device, comprising a substrate circuit (400) and a light-emitting assembly of any one of claims 1 to 8, the light-emitting assembly being bonded to the substrate circuit (400).

10. A method for manufacturing a light-emitting assembly, the light-emitting assembly being configured to bond a light-emitting diode (100) to a substrate circuit (400), the light-emitting diode (100) comprising a semiconductor sequence which is composed of at least a first type semiconductor layer, a second type semiconductor layer, and an active layer located between the first type semiconductor layer and the second type semiconductor layer, the light-emitting diode (100) further comprising a first electrical contact layer (121) electrically connected to the first type semiconductor layer, and a second electrical contact layer (122) electrically connected to the second type semiconductor layer, the method comprising:
step (1), providing a support (200) configured to support the light-emitting assembly, and coating a layer of adhesive film (300) on the support (200); and
step (2), adhering a first type of die of the light-emitting diode (100) and a second type of die of the light-emitting diode (100) different from the first type to the adhesive film (300) to obtain the light-emitting assembly, the dies of the light-emitting diodes (100) being adhered to the adhesive film (300) in batches according to the different types of the dies,
wherein a plurality of plateau-shaped protrusions (310) are provided on a surface of the adhesive film (300) and a convex surface of the plateau-shaped protrusions (310) is in contact with the light-emitting diodes (100), **characterised in that** a height of the plateau-shaped protrusion (310) is 10-20 µm which is greater than a thickness of the light-emitting diode (100).

11. The method of manufacturing a light-emitting assembly according to claim 10, wherein part or all of the adhesive film (300) between the dies of the light-emitting diodes (100) is removed to provide the plurality of of plateau-shaped protrusions (310).

12. The method for manufacturing a light-emitting assembly according to claim 10, wherein the first electrical contact layer (121) and the second electrical contact layer (122) are located on a surface of a side of the light-emitting diode (100) facing away from the adhesive film (300).

13. The method for manufacturing a light-emitting assembly according to claim 10, wherein the first type of die of the light-emitting diodes (100) and the second type of die of the light-emitting diodes (100) have different wavelengths or different sizes.

14. A method for manufacturing a light-emitting device, the light-emitting device comprising a substrate circuit (400), wherein the method comprises the method for manufacturing a light-emitting assembly of any one of claims 10 to 13, and the method for manufacturing a light-emitting device further comprises bonding the light-emitting assembly to the substrate circuit (400).

15. The method for manufacturing a light-emitting device according to claim 14, wherein the adhesive film (300) and/or the support (200) is/are removed after the light-emitting assembly is bonded to the substrate circuit (400).

## Patentansprüche

1. Lichtemittierende Baugruppe, umfassend:
eine Vielzahl von lichtemittierenden Dioden (100), wobei die lichtemittierende Diode (100) eine Halbleiterschichtenfolge (110) umfasst, die zumindest aus einer Halbleiterschicht des ersten Typs, einer Halbleiterschicht des zweiten Typs und einer aktiven Schicht besteht, die zwischen der Halbleiterschicht des ersten Typs und der Halbleiterschicht des zweiten Typs gelegen ist, wobei die lichtemittierende Diode (100) ferner eine erste elektrische Kontaktschicht (121), die mit der Halbleiterschicht des ersten Typs elektrisch verbunden ist, und eine zweite elektrische Kontaktschicht (122), die mit der Halbleiterschicht des zweiten Typs elektrisch verbunden ist, umfasst,
einen Träger (200), der dazu eingerichtet ist, die lichtemittierenden Dioden (100) zu stützen; und
eine kontinuierliche oder diskontinuierliche Klebefolie (300) zum Kleben der lichtemittierenden Dioden (100), die zwischen dem Träger (200) und den lichtemittierenden Dioden (100) vorgesehen ist, wobei die lichtemittierenden Dioden (100) auf der Klebefolie (300) in einer regelmäßigen Anordnung angeordnet sind,
worin eine Vielzahl von plateauförmigen Vorsprüngen (310) auf einer Fläche der Klebefolie (300) vorgesehen ist und eine konvexe Fläche der plateauförmigen Vorsprünge (310) mit den lichtemittierenden Dioden (100) in Kontakt steht, **dadurch gekennzeichnet, dass** eine Höhe des plateauförmigen Vorsprungs (310) 10-20 µm ist, die größer ist als eine Dicke der lichtemittierenden Diode (100).

2. Lichtemittierende Baugruppe nach Anspruch 1, worin die Klebefolie (300) ein abnehmbares Material ist, wobei die Klebefolie (300) dazu fähig ist, unter einer physischen oder chemischen Wirkung die lichtemittierenden Dioden (100) zu fixieren und die lichtemittierenden Dioden (100) auszulösen.

3. Lichtemittierende Baugruppe nach Anspruch 1, worin eine Gestalt des plateauförmigen Vorsprungs (310) ein Quader, ein Kegelstumpf, ein Prisma oder eine andere säulenförmige Struktur ist, und ein Abstand zwischen den plateauförmigen Vorsprüngen (310) 20-600 µm ist.

4. Lichtemittierende Baugruppe nach Anspruch 1, worin eine Seitenwand der lichtemittierenden Diode (100) mit einer dünnen Schicht versehen ist, die aus einem Material der Klebefolie (300) besteht, eine Dicke der dünnen Schicht (320) 3-10 µm ist, ein Brechungsindex der dünnen Schicht (320) 1,2-2 ist, eine Härte der Klebefolie (300) 15-50 J/m³ ist, wobei ein Material der Klebefolie (300) Polyimid, ultraviolettlichtempfindlichen Klebstoff, hitzeempfindlichen Klebstoff, Hydrosol oder Silikagel umfasst.

5. Lichtemittierende Baugruppe nach Anspruch 1, worin die Struktur der lichtemittierenden Diode (100) eine Face-Up-Chip-Struktur, eine Flip-Chip-Struktur oder eine vertikale Struktur umfasst, wobei die lichtemittierende Diode (100) mit einer Schutzschicht (500) auf einer Fläche, die die Klebefolie (300) berührt, und/oder an einer Seitenwand, die an die Fläche angrenzt, die die Klebefolie (300) berührt, versehen ist.

6. Lichtemittierende Baugruppe nach Anspruch 1, worin eine Kombinationsweise der regelmäßigen Anordnung eine Anordnung von verschiedenen lichtemittierenden Wellenlängenkombinationen, eine Anordnung von verschiedenen Abstandskombinationen oder eine Anordnung von verschiedenen Größenkombinationen umfasst, und vorzugsweise die Anordnung von verschiedenen Größenkombinationen eine Anordnung von verschiedenen Dicken, eine Anordnung von verschiedenen lichtemittierenden Bereichen oder eine Anordnung von verschiedenen Formen umfasst.

7. Lichtemittierende Baugruppe nach Anspruch 1, worin die lichtemittierende Baugruppe dazu eingerichtet ist, an einer Substratschaltung (400) gebunden zu werden, und eine Funktion des Überführens jeweils einer Vielzahl von lichtemittierenden Dioden (100) vom Träger (200) zur Substratschaltung (400) hat, wobei ein Material des Trägers (200) Saphir, Galliumarsenid, Silizium oder Siliziumkarbid umfasst.

8. Lichtemittierende Baugruppe nach Anspruch 1, worin die lichtemittierende Diode (100) eine Länge von 2 µm bis 5 µm, von 5 µm bis 10 µm, von 10 µm bis 20 µm, von 20 µm bis 50 µm oder von 50 µm bis 100 µm aufweist, eine Breite von 2 µm bis 5 µm, von 5 µm bis 10 µm, von 10 µm bis 20 µm, von 20 µm bis 50 µm oder von 50 µm bis 100 µm aufweist und eine Höhe von 2 µm bis 5 µm oder von 5 µm bis 10 µm aufweist.

9. Lichtemittierende Vorrichtung, umfassend eine Substratschaltung (400) und eine lichtemittierende Baugruppe nach einem der Ansprüche 1 bis 8, wobei die lichtemittierende Baugruppe an der Substratschaltung (400) gebunden ist.

10. Verfahren zur Herstellung einer lichtemittierenden Baugruppe, wobei die lichtemittierende Baugruppe dazu eingerichtet ist, eine lichtemittierende Diode (100) an einer Substratschaltung (400) zu binden, wobei die lichtemittierende Diode (100) eine Halbleiterfolge umfasst, die zumindest aus einer Halbleiterschicht des ersten Typs, einer Halbleiterschicht des zweiten Typs und einer aktiven Schicht besteht, die zwischen der Halbleiterschicht des ersten Typs und der Halbleiterschicht des zweiten Typs gelegen ist, wobei die lichtemittierende Diode (100) ferner eine erste elektrische Kontaktschicht (121), die mit der Halbleiterschicht des ersten Typs elektrisch verbunden ist, und eine zweite elektrische Kontaktschicht (122), die mit der Halbleiterschicht des zweiten Typs elektrisch verbunden ist, umfasst, wobei das Verfahren umfasst:
Schritt (1), Vorsehen eines Trägers (200), der dazu eingerichtet ist, die lichtemittierende Baugruppe zu stützen, und Überziehen einer Schicht von Klebefolie (300) auf dem Träger (200); und
Schritt (2), Kleben eines ersten Typs von Plättchen der lichtemittierenden Diode (100) und eines zweiten Typs von Plättchen der lichtemittierenden Diode (100), der anders als der erste ist, auf der Klebefolie (300), um die lichtemittierende Baugruppe zu erhalten, wobei die Plättchen der lichtemittierenden Dioden (100) auf der Klebefolie (300) in Partien je nach den verschiedenen Typen der Plättchen geklebt sind,
worin eine Vielzahl von plateauförmigen Vorsprüngen (310) auf einer Fläche der Klebefolie (300) vorgesehen ist und eine konvexe Fläche der plateauförmigen Vorsprünge (310) mit den lichtemittierenden Dioden (100) in Kontakt steht, **dadurch gekennzeichnet, dass** eine Höhe des plateauförmigen Vorsprungs (310) 10-20 µm ist, die größer ist als eine Dicke der lichtemittierenden Diode (100).

11. Verfahren zur Herstellung einer lichtemittierenden Baugruppe nach Anspruch 10, worin ein Teil oder die ganze Klebefolie (300) zwischen den Plättchen der lichtemittierenden Dioden (100) abgenommen wird, um die Vielzahl von plateauförmigen Vorsprüngen (310) bereitzustellen.

12. Verfahren zur Herstellung einer lichtemittierenden Baugruppe nach Anspruch 10, worin die erste elektrische Kontaktschicht (121) und die zweite elektrische Kontaktschicht (122) auf einer Fläche einer Seite der lichtemittierenden Diode (100) gelegen sind, die von der Klebefolie (300) abgewandt ist.

13. Verfahren zur Herstellung einer lichtemittierenden Baugruppe nach Anspruch 10, worin der erste Typ von Plättchen der lichtemittierenden Dioden (100) und der zweite Typ von Plättchen der lichtemittierenden Dioden (100) verschiedene Wellenlängen oder verschiedene Größen haben.

14. Verfahren zur Herstellung einer lichtemittierenden Vorrichtung, wobei die lichtemittierende Vorrichtung eine Substratschaltung (400) umfasst, worin das Verfahren das Verfahren zur Herstellung einer lichtemittierenden Baugruppe nach einem der Ansprüche 10 bis 13 umfasst und das Verfahren zur Herstellung einer lichtemittierenden Vorrichtung ferner das Binden der lichtemittierenden Baugruppe an der Substratschaltung (400) umfasst.

15. Verfahren zur Herstellung einer lichtemittierenden Vorrichtung nach Anspruch 14, worin die Klebefolie (300) und/oder der Träger (200) abgenommen wird/werden, nachdem die lichtemittierende Baugruppe an der Substratschaltung (400) gebunden ist.

## Revendications

1. Ensemble électroluminescent, comprenant :
une pluralité de diodes électroluminescentes (100), la diode électroluminescente (100) comprenant une séquence de couches semiconductrices (110) composée d'au moins une couche semi-conductrice de premier type, une couche semi-conductrice de second type et une couche active située entre la couche semi-conductrice de premier type et la couche semi-conductrice de second type, la diode électroluminescente (100) comprenant en outre une première couche de contact électrique (121) électriquement connectée à la couche semi-conductrice de premier type et une seconde couche de contact électrique (122) électriquement connectée à la couche semi-conductrice de second type,
un support (200) configuré pour supporter les diodes électroluminescentes (100) ; et
un film adhésif continu ou discontinu (300) pour faire adhérer les diodes électroluminescentes (100), fourni entre le support (200) et les diodes électroluminescentes (100), les diodes électroluminescentes (100) étant agencées sur le film adhésif (300) en un agencement régulier, dans lequel une pluralité de saillies en forme de plateau (310) sont fournies sur une surface du film adhésif (300) et une surface convexe des saillies en forme de plateau (310) est en contact avec les diodes électroluminescentes (100), **caractérisé en ce qu'**une hauteur de la saillie en forme de plateau (310) est de 10-20 µm, ce qui est supérieur à une épaisseur de la diode électroluminescente (100).

2. Ensemble électroluminescent selon la revendication 1, dans lequel le film adhésif (300) est un matériau amovible, le film adhésif (300) étant capable de fixer les diodes électroluminescentes (100) et de décoller les diodes électroluminescentes (100) sous une action physique ou chimique.

3. Ensemble électroluminescent selon la revendication 1, dans lequel une forme de la saillie en forme de plateau (310) est un parallélépipède, un cône tronqué, un prisme ou une autre structure colonnaire, et un espacement entre les saillies en forme de plateau (310) est de 20-600 µm.

4. Ensemble électroluminescent selon la revendication 1, dans lequel une paroi latérale de la diode électroluminescente (100) est dotée d'un film mince constitué d'un matériau du film adhésif (300), une épaisseur du film mince (320) étant de 3-10 µm, un indice de réfraction du film mince (320) étant de 1,2-2, une dureté du film adhésif (300) étant de 15-50 J/m³, un matériau du film adhésif (300) comprenant un polyimide, un adhésif photosensible aux ultraviolets, un adhésif thermosensible, un hydrosol ou un gel de silice.

5. Ensemble électroluminescent selon la revendication 1, dans lequel la structure de la diode électroluminescente (100) comprend une structure de puce face visible, une structure de puce retournée ou une structure verticale, la diode électroluminescente (100) étant dotée d'une couche protectrice (500) sur une surface en contact avec le film adhésif (300) et/ou sur une paroi latérale adjacente à la surface en contact avec le film adhésif (300).

6. Ensemble électroluminescent selon la revendication 1, dans lequel une combinaison de l'agencement régulier comprend un agencement de différentes combinaisons de longueurs d'onde d'émission de lumière, un agencement de différentes combinaisons d'espacement, ou un agencement de différentes combinaisons de taille, et de préférence, l'agencement de différentes combinaisons de taille inclut un agencement de différentes épaisseurs, un agencement de différentes zones d'émission de lumière ou un agencement de différentes formes.

7. Ensemble électroluminescent selon la revendication 1, dans lequel l'ensemble électroluminescent est configuré pour être lié à un circuit de substrat (400), et présente une fonction de transfert d'une pluralité de diodes électroluminescentes (100) du support (200) au circuit de substrat (400) simultanément, un matériau du support (200) comprenant du saphir, de l'arséniure de gallium, du silicium ou du carbure de silicium.

8. Ensemble électroluminescent selon la revendication 1, dans lequel la diode électroluminescente (100) se situe dans une longueur de 2 µm à 5 µm, de 5 µm à 10 µm, de 10 µm à 20 µm, de 20 µm à 50 µm, ou de 50 µm à 100 µm, dans une largeur de 2 µm à 5 µm, de 5 µm à 10 µm, de 10 µm à 20 µm, de 20 µm à 50 µm, ou de 50 µm à 100 µm, et dans une hauteur de 2 µm à 5 µm, ou de 5 µm à 10 µm.

9. Dispositif électroluminescent, comprenant un circuit de substrat (400) et un ensemble électroluminescent selon l'une quelconque des revendications 1 à 8, l'ensemble électroluminescent étant lié au circuit de substrat (400).

10. Procédé de fabrication d'un ensemble électroluminescent, l'ensemble électroluminescent étant configuré pour lier une diode électroluminescente (100) à un circuit de substrat (400), la diode électroluminescente (100) comprenant une séquence semi-conductrice qui est composée d'au moins une couche semi-conductrice de premier type, une couche semi-conductrice de second type et une couche active située entre la couche semi-conductrice de premier type et la couche semi-conductrice de second type, la diode électroluminescente (100) comprenant en outre une première couche de contact électrique (121) électriquement connectée à la couche semi-conductrice de premier type, et une seconde couche de contact électrique (122) électriquement connectée à la couche semi-conductrice de second type, le procédé comprenant :
étape (1), la fourniture d'un support (200) configuré pour supporter l'ensemble électroluminescent, et l'application d'une couche de film adhésif (300) sur le support (200) ; et
étape (2), l'adhérence d'un premier type de puce de la diode électroluminescente (100) et d'un second type de puce de la diode électroluminescente (100) différent du premier type sur le film adhésif (300) pour obtenir l'ensemble électroluminescent, les puces des diodes électroluminescentes (100) étant collées sur le film adhésif (300) par lots en fonction des différents types des puces,
dans lequel une pluralité de saillies en forme de plateau (310) sont fournies sur une surface du film adhésif (300) et une surface convexe des saillies en forme de plateau (310) est en contact avec les diodes électroluminescentes (100), **caractérisé en ce qu'**une hauteur de la saillie en forme de plateau (310) est de 10-20 µm, ce qui est supérieur à une épaisseur de la diode électroluminescente (100).

11. Procédé de fabrication d'un ensemble électroluminescent selon la revendication 10, dans lequel une partie ou la totalité du film adhésif (300) entre les puces des diodes électroluminescentes (100) est retirée pour fournir la pluralité de saillies en forme de plateau (310).

12. Procédé de fabrication d'un ensemble électroluminescent selon la revendication 10, dans lequel la première couche de contact électrique (121) et la seconde couche de contact électrique (122) sont situées sur une surface d'un côté de la diode électroluminescente (100) opposé au film adhésif (300).

13. Procédé de fabrication d'un ensemble électroluminescent selon la revendication 10, dans lequel le premier type de puce des diodes électroluminescentes (100) et le second type de puce des diodes électroluminescentes (100) présentent des longueurs d'onde différentes ou des tailles différentes.

14. Procédé de fabrication d'un dispositif électroluminescent, le dispositif électroluminescent comprenant un circuit de substrat (400), dans lequel le procédé comprend le procédé de fabrication d'un ensemble électroluminescent selon l'une quelconque des revendications 10 à 13, et le procédé de fabrication d'un dispositif électroluminescent comprend en outre la liaison de l'ensemble électroluminescent au circuit de substrat (400).

15. Procédé de fabrication d'un dispositif électroluminescent selon la revendication 14, dans lequel le film adhésif (300) et/ou le support (200) est/sont retiré(s) après que l'ensemble électroluminescent est lié au circuit de substrat (400).
